# EUROPEAN PATENT SPECIFICATION

(11) **EP 2 605 625 B1**
(45) Date of publication and mention of the grant of the patent: **21.02.2018**
(21) Application number: 12197377.0
(22) Date of filing: 15.12.2012
(51) Int. Cl.: H05K 3/38, H05K 1/03, H05K 3/02

(54) **PCB structure with a silicone layer as adhesive**
PCB-Struktur mit einer Silikonschicht als Haftmittel
Structure de PCB avec une couche de silicone comme adhésif

(30) Priority: 16.12.2011 TW 100146896
(43) Date of publication of application: 19.06.2013
(73) Proprietor: Prologium Holding Inc., Grand Cayman, KY1-1104 (KY)
(72) Inventor: Yang, Szu-Nan, Taipei (TW)
(74) Representative: Chaillot, Geneviève

(56) References cited:
- US-A- 4 639 285
- US-A- 4 765 860
- US-A1- 2003 145 940
- US-A1- 2007 037 950
- US-A1- 2009 056 995
- US-A1- 2010 323 208
- US-A1- 2011 114 371
- US-A1- 2011 290 543

## Description

### BACKGROUND OF THE INVENTION

### Field of Invention

The present invention relates to an PCB (printed circuit board) structure, in particular to an PCB structure using a silicone layer to combine the metal layer and the substrate.

### Related Art

Since a flexible printed circuit board (FPC) assembly has flexibility by which the flexible printed circuit board assembly can be bent by itself, the flexible printed circuit board assembly has been used in various kinds of electrical appliances. For example, a flexible printed circuit board can be installed between a main body and an openable display unit of a notebook computer to transmit an electrical signal between the main body and the display unit, or can be installed between a main body and a movable pickup assembly of an optical disc drive in a computer to transmit a signal therebetween.

A flexible copper clad laminate (FCCL) is main product of the FPC. The FCCL is manufactured by gluing together a metallic foil such as a copper foil to the surface of a heat-resistant film represented by a polyimide film via an adhesive formed of an epoxy system resin adhesive, such as epoxy resin, polyester, or acrylic resin. The FCCL is normally produced by hot-pressing the layered structure at around 180 °C. Due to the main chain of the epoxy system resin adhesive is rigid, there has a problems known as warping phenomenon of the laminate itself during the hot-pressing.

To solve this problem, the adhesive layer of the above three-layer flexible copper clad laminate is eliminated, so it is called "two-layer flexible copper clad laminate" (2L FCCL). It is manufactured by a casting method, sputtering method, or lamination method to form the copper foil on the surface of the substrate film represented by a polyimide (PI) film.

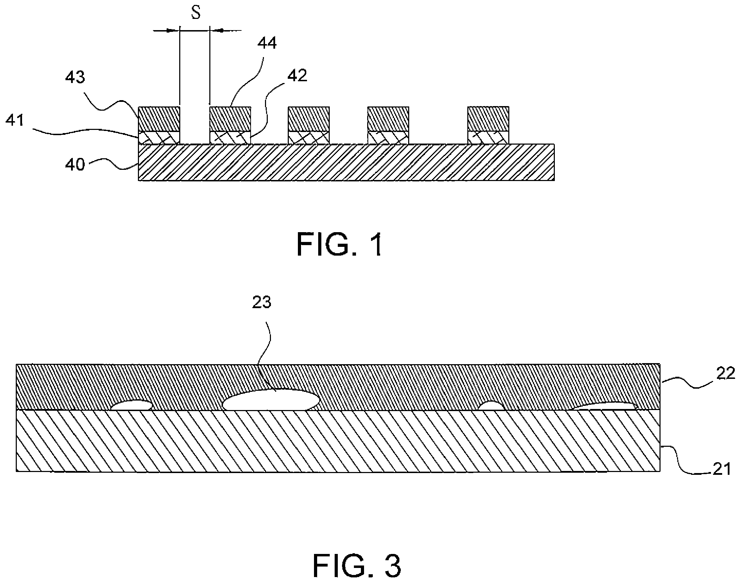

However, because of the characteristic of the material, the FCCL, including three-layer and two-layer, has low ion-migration resistance. The material of the substrate, polyimide, and the adhesive, such as epoxy resin, or acrylic resin, are high polarity and hydrophilic. For example, the FCCL is utilized in a fine pitch wiring and high voltage appliances, such as LCD (liquid crystal display), OLED (Organic Light-Emitting Diode), or plasma display. Please refer to FIG. 1, it shows a three-layer flexible copper clad laminate. A first lead 43 and a second lead 44 are formed on the adhesive layer 41, 42 and the substrate 40. During the high voltage operation, these devices are known to have the drawback that a short distance S between leads 43, 44 causes an ion migration phenomenon to the copper used as the wiring or electrode. It often results in electrical failures such as increased leakage current flow and short-circuiting between leads 43, 44. On the other hand, for the two-layer flexible copper clad laminate, due to the substrate, PI, is also high polarity and hydrophilic. The drawback, the ion migration phenomenon, still exists.

US 4 639 285 A, US 4 765 860 A, US 2011/114371 A1, US 2009/056995 A1, US 2011/290543 A1 and US 2003/145940 A1 disclose PCB structures according to prior art that comprise a silicone layer between a substrate and a metal layer.

### SUMMARY OF THE INVENTION

It is an objective of this invention to provide a PCB structure. The silicone is utilized to be the adhesive between the metal layer and the substrate. The silicone is sufficiently soft to absorb the deformation due to heat-shrink to prevent warping and bent during high temperature processing.

Another objective of this invention is to provide a PCB structure. The ion-migration resistance is raised. The problems of unclear signal and voltage drop caused by moisture are overcame due to the characteristic of non-polar and non-hydrophile of the silicone.

It is an objective of this invention to provide a PCB structure. The silicone layer has two modified silicone layers disposed two sides thereon to enhance the adhesion between the silicone and substrate/metal layer. The problems of producing bubbles or easy to peel off are solved.

This invention discloses a PCB structure. The PCB structure includes a substrate, a silicone layer, a metal layer, a first modified silicone layer and a second modified silicone layer. The first modified silicone layer and the second modified silicone layer are formed slowly for curing and the silicone layer is formed fast curing. The silicone layer, the first modified silicone layer and the second silicone layer are disposed between the substrate and the metal for adhesion. The silicone layer is sufficiently soft to absorb the deformation of the metal and the substrate due to heat-shrink to prevent warping and bent during high temperature processing. Due to the characteristic of non-polar and non-hydrophile of the silicone layer, the problems caused by the high polarity and hydrophilic material, such as polyimide (PI), epoxy resin, or acrylic resin, are solved. The ion-migration resistance of this PCB structure is raised. The problems of unclear signal and voltage drop caused by moisture are overcame due to the characteristic of non-polar and non-hydrophile of the silicone.

Furthermore, to enhance the adhesion between the silicone and substrate/metal layer, the silicone layer has two modified silicone layers disposed two sides thereon. The problems of producing bubbles or easy to peel off are solved. The modified silicone layer is modified the interfacial tension and the polarity thereof to enhance the adhesion for different materials.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from this detailed description.

### BRIEF DESCRIPTION OF THE DRAWINGS

The present invention will become more fully understood from the detailed description given hereinbelow illustration only, and thus are not limitative of the present invention, and wherein:
FIG. 1 illustrates the example of the conventional PCB structure when utilizing in a fine pitch wiring and high voltage appliances.
FIG. 2 illustrates the PCB structure according to the present invention when utilizing in a fine pitch wiring and high voltage appliances.
FIG. 3 illustrates the example of the conventional coating silicone layer.
FIG. 4 illustrates the PCB structure of this present invention.

### DETAILED DESCRIPTION OF THE INVENTION

Silicones are synthetic compounds with a variety of forms and uses. Typically heat-resistant and rubber-like, they are used in sealants, adhesives, lubricants, medical applications, cookware, and insulation. Some of the most useful properties of silicones include low thermal conductivity, low chemical reactivity, low toxicity, and thermal stability. Also, silicones have excellent resistance to oxygen, ozone, and ultraviolet (UV) light and good electrical insulation. Because silicone can be formulated to be electrically insulative or conductive, it is suitable for a wide range of electrical applications. The silicone exhibits good fluidity and adhesion when melting, and is sufficiently soft after cured. Also, the silicone is non-polar and non-hydrophile. Therefore, it is suitable to replace epoxy resin as a material of adhesive.

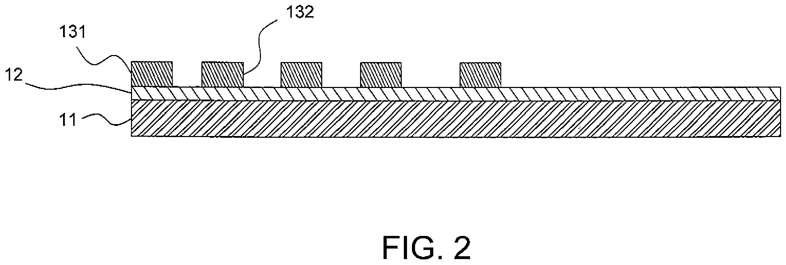

Moreover, the silicone is non-polar and non-hydrophile. Please refer to FIG. 2, when the PCB structure is utilized in a fine pitch wiring and high voltage appliances, such as LCD (liquid crystal display), OLED (Organic Light-Emitting Diode), or plasma display, at least one first lead 131 and one second lead 132 are formed on the metal layer 13. Unlike a conventional PCB structure, the silicone layer 12 is non-polar and non-hydrophile. Even the substrate 11 represented by a polyimide (PI) is high polarity and hydrophilic, the silicone layer 12 will stop the ion migration phenomenon between the first lead 131 and the second lead 132. The problems of unclear signal and voltage drop will not be happened.

However, the silicone has a problem for adhesion. The silicone will perform both the condensation reaction and the addition reaction during curing. The structure cured by a condensation reaction has less adhesion force than an addition reaction. Also the byproduct of the condensation reaction is hydrogen, which is easy to produce bubbles. As refer to FIG. 43, the silicone layer 22 is disposed on the substrate 21 with different material. During polymerization, the gas, i.e. hydrogen, is moved randomly. When blocking by the substrate 21, due to the substrate 21 is made of compact material, such as metal, glass, or polymer, the gas is heaped up to form bubbles 23 at the interface therebetween. When there have bubbles 23 at the interface, the structure is easy to peel off.

General speaking, the silicone is utilized in fill. In other words, one side of the silicone layer 22 is free, as shown in FIG. 3. If the polymerization is performed slowly, the produced gas can be exhausted slowly. However, in this invention, the silicone layer 12 is placed between the substrate 11 and the metal layer 13. It has to perform hot pressing or thermal polymerization for curing, that is, the silicone layer 12 is formed fast curing. That will produces more gases. When the gas is moved randomly and blocked by the substrate 11 and the metal layer 13. The heaped gas bubbles would crack the adhesion interface therebetween. Also, the gas bubbles will be merged to a larger one to make the adhesion be weaker.

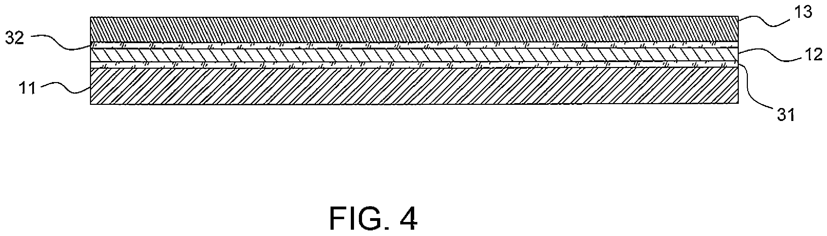

Please refer to FIG. 4, the PCB (printed circuit board) structure includes a substrate 11, a silicone layer 12 and a metal layer 13. The material of the substrate 11 includes polyimide (PI), polyethylene terephthalate (PET), polyethylene naphthalate (PEN), glass, glass fiber, and liquid crystal polymer to form a flexible PCB or an inflexible PCB. The silicone layer 12 is disposed between the substrate 11 and the metal layer 13 to be as adhesive therein. The silicone exhibits good fluidity and adhesion when melting. It is suitable to be an adhesive. For example, the silicone is disposed on the substrate 11 by coating to form the silicone layer 12. The metal layer 13 is disposed on the silicone layer 12 and then is cured by a baking process. After cured, the silicone layer 12 is sufficiently soft to be as a buffer to absorb the deformation due to heat-shrink between the metal layer 13 and the substrate 11 to prevent warping and bent during high temperature processing. The wiring may be formed by on the metal layer 13 by etching or other processing. The further protective layer, solder mask, and etc. may also be formed thereon. The material of the metal layer 13 is copper (Cu), aluminum (Al), nickel (Ni), gold (Au), silver (Ag), tin (Sn) or an alloy comprised of at least one of the foregoing metals.

To solve the problem mentioned above, the silicone layer 12 has two modified silicone layers 31, 32 disposed two sides thereon. The first modified silicone layer 31 is disposed between the silicone layer 12 and the substrate 11. The second modified silicone layer 32 is disposed between the silicone layer 12 and the metal layer 13. The modified silicone layers 31, 32 are modified the interfacial tension and the polarity thereof depending on the materials of the substrate 11 and the metal layer 13. Therefore, the good adhesion situations are presented on the interfaces between the first modified silicone layer 31 and the substrate 11, and the second modified silicone layer 32 and the metal layer 13. Also, the amounts of the produced gas bubbles are decreased and the size of the gas bubbles is lessened. The modified silicone layers 31, 32 are modified by adjusting a proportion of condensation-type silicone and addition-type silicone and/or by adding Epoxy, Acrylic Acid or a combination thereof into silicone.

Take the following forming method for example, the modified silicone layers 31, 32 are formed on the substrate 11 and the metal layer 13 respectively. Then the polymerization is performed slowly for curing. Due to one side is free, the produced gas can be exhausted. Also, the modified silicone layers 31, 32 are modified depending on the materials of the substrate 11 and the metal layer 13. The good adhesion situations are presented on the interfaces between the first modified silicone layer 31 and the substrate 11, and the second modified silicone layer 32 and the metal layer 13. Then the silicone layer 12 is disposed therebetween for curing to form the above-mentioned structure.

Due to the silicone layer 12 is disposed between the modified silicone layers 31, 32, which made of the same or substantially the same material, the adhesion force therebetween is high. Even the gas is produced, it is not easy to weaken the adhesion structure. Also, due to the silicone is not a compact material as the substrate 11 or the metal layer 13. In micro-view, the silicone has larger hole inside. Even the silicone layer 12 is disposed between the modified silicone layers 31, 32 for curing, the produced gas is easily to be exhausted from the modified silicone layers 31, 32, and is not easy to heap up to form bubbles. The intermolecular forces between the silicone layer 12 and the modified silicone layers 31, 32 are equal. The gas flows inside are uniform. The gas bubbles will not easy to merge to a larger one. Therefore, the good adhesion situations are presented on the interfaces between the modified silicone layers 31, 32 and the silicone layer 12.

## Claims

1. A printed circuit board (PCB) structure, comprising:
a substrate (11);
a silicone layer (12);
a first modified silicone layer (31) disposed between the substrate and the silicone layer;
a metal layer (13); **characterized by** having a second modified silicone layer disposed between the metal layer and the silicone layer;
wherein the first modified silicone layer and the second modified silicone layer are obtainable by performing the polymerization slowly for curing on the substrate and the metal layer respectively with the other side free so that the produced gas can be exhausted and the silicone layer is obtainable by thermal polymerization for curing while disposed between the modified silicone layers through which the produced gas can be exhausted.

2. The PCB structure of claim 1, wherein each modified silicone layer has the interfacial tension and the polarity thereof modified.

3. The PCB structure of claim 2, wherein each modified silicone layer is modified by adjusting a proportion of condensation-type silicone and addition-type silicone.

4. The PCB structure of claims 2 or 3, wherein each modified silicone layer is modified by adding Epoxy, Acrylic Acid or a combination thereof into silicone.

5. The PCB structure of claim 1, wherein the silicone layer is obtainable by hot pressing.

## Patentansprüche

1. Leiterplatten(PCB)-Struktur mit:
einem Substrat (11);
einer Silikonschicht (12);
einer ersten modifizierten Silikonschicht (31) zwischen dem Substrat und der Silikonschicht;
einer Metallschicht (13); **gekennzeichnet dadurch, dass** sie eine zweite modifizierte Silikonschicht aufweist, die zwischen der Metallschicht und der Silikonschicht angeordnet ist;
wobei die erste modifizierte Silikonschicht und die zweite modifizierte Silikonschicht durch langsames Ausführen der Polymerisation zur Härtung auf dem Substrat bzw. der Metallschicht erhältlich sind, wobei die anderen Seite frei ist, so dass das hergestellte Gas abgelassen werden kann,
und die Silikonschicht ist erhältlich durch Wärmepolymerisation zur Härtung, während sie zwischen den modifizierten Silikonschichten angeordnet ist, durch die das hergestellte Gas abgelassen werden kann.

2. PCB-Struktur nach Anspruch 1, wobei jede modifizierte Silikonschicht modifiziert Grenzflächenspannung mit modifizierter Polarität hat.

3. PCB-Struktur nach Anspruch 2, wobei jede modifizierte Silikonschicht modifiziert wird, indem man ein Verhältnis von kondensationsvernetzendem Silicon und additionsvernetzendem Silikon einstellt.

4. PCB-Struktur nach den Ansprüchen 2 oder 3, wobei jede modifizierte Silikonschicht durch Hinzufügen von Epoxid, Akrylsäure oder einer Kombination davon in das Silikon modifiziert wird.

5. PCB-Struktur nach Anspruch 1, wobei die Silikonschicht durch Heißpressen erhältlich ist.

## Revendications

1. Structure de carte de circuits imprimés (PCB), comprenant :
un substrat (11) ;
une couche de silicone (12) ;
une première couche de silicone modifiée (31) disposée entre le substrat et la couche de silicone ;
une couche métallique (13) ; **caractérisée** comme ayant une seconde couche de silicone modifiée disposée entre la couche métallique et la couche de silicone ;
la première couche de silicone modifiée et la seconde couche de silicone modifiée pouvant être obtenues par conduite de la polymérisation lentement pour un durcissement sur le substrat et la couche métallique respectivement avec l'autre côté libre de telle sorte que le gaz produit puisse s'échapper et la couche de silicone pouvant être obtenue par polymérisation thermique pour un durcissement alors qu'elle est disposée entre les couches de silicone modifiées à travers lesquelles le gaz produit peut s'échapper.

2. Structure de PCB selon la revendication 1, dans laquelle chaque couche de silicone modifiée a la tension interfaciale et la polarité de celle-ci modifiées.

3. Structure de PCB selon la revendication 2, dans laquelle chaque couche de silicone modifiée est modifiée par ajustement d'une proportion de silicone de type de condensation et de silicone de type d'addition.

4. Structure de PCB selon l'une des revendications 2 ou 3, dans laquelle chaque couche de silicone modifiée est modifiée par addition d'Epoxy, d'Acide Acrylique ou d'une combinaison de ceux-ci dans le silicone.

5. Structure de PCB selon la revendication 1, dans laquelle la couche de silicone peut être obtenue par pressage à chaud.
